Europäisches Patentamt

European Patent Office

Office européen des brevets

(11) Publication number: **0 334 374**
**A2**

## (12) EUROPEAN PATENT APPLICATION

(21) Application number: **89105286.2**

(22) Date of filing: **23.03.89**

(51) Int. Cl.⁴: **H01L 39/24 , C04B 35/50**

(30) Priority: **24.03.88 JP 71519/88**

(43) Date of publication of application:
**27.09.89 Bulletin 89/39**

(84) Designated Contracting States:
**DE FR GB**

(71) Applicant: **Mitsubishi Metal Corporation**
**No. 5-2, Ohtemachi, 1-chome Chiyoda-ku**
**Tokyo 100(JP)**

(72) Inventor: **Takeshita, Takuo Mitsubishi Metal**
**Corporation**
**Chuo Kenkyujo 297, Kitabukurocho 1-chome**
**Omiya-shi Saitama 330(JP)**
Inventor: **Sugihara, Tadashi Mitsubishi Metal**
**Corporation**
**Chuo Kenkyujo 297, Kitabukurocho 1-chome**
**Omiya-shi Saitama 330(JP)**
Inventor: **Kondo, Hideyuki Mitsubishi Metal**
**Corporation**
**Chuo Kenkyujo 297, Kitabukurocho 1-chome**
**Omiya-shi Saitama 330(JP)**
Inventor: **Fujino, Shuichi Mitsubishi Metal**
**Corporation**
**Chuo Kenkyujo 297, Kitabukurocho 1-chome**
**Omiya-shi Saitama 330(JP)**

(74) Representative: **Pätzold, Herbert, Dr.-Ing.**
**Widenmayerstrasse 49**
**D-8000 München 22(DE)**

(54) Process of forming a superconductive wiring strip in low temperature ambient.

(57) According to the present invention, a superconductive oxide is deposited on a substrate (9) with an assistance of a ultra-violet light radiation (U.V.), and an oxygen gas (6) is directly supplied to the major surface of the substrate, so that active oxygen atoms are produced around the substrate and promote the crystal growth of the superconductive oxide even if the deposition is carried out in a relatively low temperature ambient not greater than about 650 degrees in centigrade.

FIG. 1

## PROCESS OF FORMING A SUPERCONDUCTIVE WIRING STRIP IN LOW TEMPERATURE AMBIENT

### FIELD OF THE INVENTION

This invention relates to a process of forming a superconductive wiring strip and, more particularly, to deposition techniques capable of being carried out at a low temperature ambient.

### DESCRIPTION OF THE RELATED PRIOR-ART

Research and development efforts are made for superconductive wiring strips providing interconnections of an integrated circuit, and various deposition techniques are applied to the formation process. One of the attractive candidates is an application of the vapor-phase epitaxial techniques, however, a problem is encountered in the application of the vapor phase epitaxial techniques to the fabrication process of semiconductor device in that undesirable diffusion takes place during the deposition, which results in deformation of profiles of implanted impurities. This is because of the fact that the deposition be carried out in a high temperature ambient greater than about 700 degrees in centigrade. If a complex oxide is deposited in a relatively low temperature ambient not greater than about 700 degrees in centigrade, the superconductivity hardly takes place in the deposited oxide due to incomplete crystal structure. This requires that the deposition is carried out in a high temperature ambient greater than about 700 degrees in centigrade or that an annealing is carried out at about 900 degrees in centigrade after the low temperature deposition.

In addition to the deformation of the profiles, when the superconductive strips are deposited on the uppermost insulating film of the structure, a high temperature ambient is liable to destroy lower level interconnections of aluminum or an aluminum alloy, because aluminum or the aluminum alloy have low melting points less than 700 degrees in centigrade.

### SUMMARY OF THE INVENTION

It is therefore an important object of the present invention to provide a deposition technique for formation of a superconductive oxide carried out at a relatively low temperature ambient.

To accomplish this object, the present invention proposes to deposit a superconductive oxide in an oxygen-rich ambient assisted with an ultra-violet light radiation. This is because of the fact that oxygen is activated with the assistance of the ultra-violet light radiation and, accordingly, the crystal growth is promoted even if the deposition ambient is relatively low.

In accordance with the present invention, there is provided a process of forming a wiring strip of a superconductive oxide, comprising the steps of: a) preparing a source of an oxygen gas, a source for a complex oxide, an intermediate structure of a semiconductor device and a vapor-phase crystal growth system equipped with a source of an ultra-violet light radiation; b) placing the source for the complex oxide and the intermediate structure of the semiconductor device in the vapor-phase crystal growth system; c) creating a relatively low temperature ambient around the intermediate structure of the semiconductor device; and d) producing a vapor of the complex oxide in the presence of the oxygen gas with the assistance of the ultra-violet light radiation for depositing the superconductive oxide on the intermediate structure of the semiconductor device.

In one process, the oxygen gas blows on a major surface of the intermediate structure where the superconductive oxide is deposited, and the direct blowing is conducive to exposing the intermediate structure of the semiconductor device to oxygen atoms decomposed from the oxygen gas. If the oxygen gas contains a promotive gas formed of, for example, nitrogen, ammonia or a gaseous mixture containing nitrogen and hydrogen, the oxygen is effectively decomposed to produce the active oxygen atoms. By virtue of the ultra-violet light radiation, the superconductive wiring strip is formed in the relatively low temperature ambient not greater than about 650 degrees in centigrade. If the promotive gas is contained in the gaseous mixture, the superconductive wiring strip is formed in the relatively low temperature ambient not greater than about 600 degrees in centigrade.

### BRIEF DESCRIPTION OF THE DRAWINGS

The features and advantages of a process of forming a superconductive wiring strip according to the present invention will be more clearly understood from the following description taken in conjunction with the accompanying drawings in which:

Fig. 1 is a schematic view showing the arrangement of an RF magnetron sputtering system used in a process according to the present invention;

· Fig. 2 is a schematic view showing the arrangement of a vacuum evaporation system used in another process according to the present invention; and

Fig. 3 is a schematic view showing the arrangement of a sputtering system used in still another process according to the present invention.

## DESCRIPTION OF THE PREFERRED EMBODIMENTS

### First embodiment

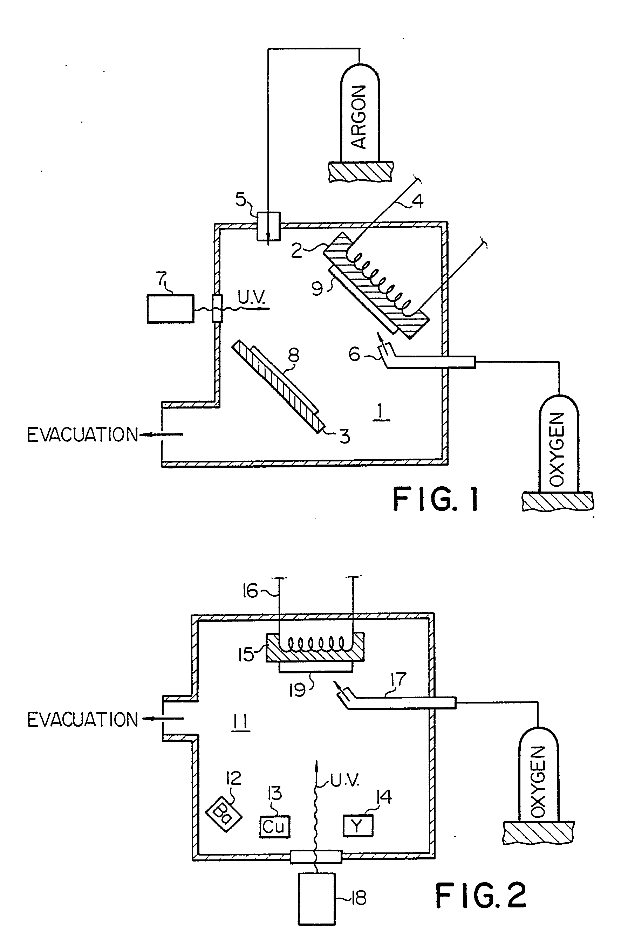

Referring first to Fig. 1 of the drawings, an RF magnetron sputtering system is provided with a sputtering chamber 1 where a wafer retainer 2, a target holder 3, an electron emitter (not shown) and a magnet unit (not shown) is arranged to carry out a sputtering. The wafer retainer 2 is assisted with a heating coil 4 coupled to a source of electric power (not shown), and a gas nozzle 5 for an argon gas is directed to the target holder 3. Another gas nozzle 6 for an oxygen gas is directed to the wafer retainer 2, and a mercury lamp 7 is provided for an ultra-violet light radiation ( which is abbreviated as "U.V." in the drawings). The mercury lamp 7 produces an ultra-violet light with a wavelength of about 2537 angstroms.

A process according to the present invention starts with preparation of a target 8 of a superconductive oxide represented by a molecular formula of $YBa_2Cu_{3.6}O_x$ as well as a single crystal magnesium oxide substrate 9 with the orientation of (100). The target 8 is attached to the target holder 3, and the magnesium oxide substrate 9 is mounted on the wafer retainer 2. The target 8 is spaced apart from the magnesium oxide substrate 9 by a distance of about 80 millimeter.

The magnesium oxide substrate 9 is heated to about 650 degrees in centigrade by using the heating coil 4, and a sputtering starts in the presence of the oxygen gas with an assistance of the ultra-violet light radiation. Namely, an argon gas ambient of about $10^{-2}$ torr is created in the target chamber 1, and a plasma is produced around the target 8 by an electron emission at about 200 watts. The plasma is guided to the target 8 by the agency of the magnet unit (not shown), so that the target 8 is subjected to a plasma bombardment. With the plasma bombardment, the superconductive oxide is sputtered from the target 8 to the magnesium oxide substrate 9 and, accordingly, is deposited on the magnesium oxide substrate 9. The oxygen gas of about $5 \times 10^{-3}$ torr has been supplied to the major surface of the magnesium oxide substrate 9 and decomposed with the assistance of the ultra-violet light radiation of about 1 kilo-watt. The excited oxygen molecules and the oxygen atoms effectively promote the crystal growth of the superconductive oxide, and the superconductive oxide is deposited to a thickness of about 1.5 micron, followed by an appropriate lithography stage for pattering a wiring strip. The wiring strip thus formed shows the superconductivity at about 52 degrees in Kelvin scale.

For comparison use, another wiring strip is formed in the same sputtering conditions without any ultra-violet light radiation. The wiring strip formed without any ultra-violet light radiation is about 15 ohm-cm at the room temperature, but no superconductivity takes place in the wiring strip. However, if the wiring strip is formed at about 710 degrees in centigrade without any ultra-violet light radiation, the wiring strip shows the superconductivity at about 73 degrees in Kelvin scale.

Moreover, still another wiring strip is formed in the same sputtering conditions except for the heating temperature and the contents of the gas supplied to the major surface of the magnesium oxide substrate 9. Namely, nitrogen gas of about 5 % by volume is mixed into the oxygen gas, and the nitrogen gas promotes the decomposition of the oxygen in the presence of the ultra-violet light radiation. By virtue of the much active oxygen atoms, the wiring strip shows the superconductivity at about 60 degrees in Kelvin scale even if the deposition is carried out on the substrate 9 heated to about 600 degrees in centigrade.

Various promotive gases are mixed into the oxygen gas, and depositions are carried out with these gaseous mixture containing the oxygen and the promotive gas, respectively, in the same depositing conditions. The results are indicated in Table 1.

Table 1

| Promotive gas % by volume | Gaseous mixture milli-torr | Critical temperature degrees in Kelvin |
|---|---|---|
| nitrogen: 10 | 20 | 45 |
| nitrogen: 5 | | |
| hydrogen: 1 | 5 | 55 |
| hydrogen: 3 | 15 | 52 |

The mixture of nitrogen and hydrogen is replacable with ammonia gas.

In the process described hereinbefore, the wiring strip is formed on the magnesium oxide substrate 9, however, the wiring strip is deposited on an intermediate structure of a semiconductor device in a practical application.


Second embodiment

Turning to Fig. 2 of the drawings, a vacuum evaporation system is provided with an evaporation chamber 11. In the evaporation chamber 11, there are three sources of elements 12, 13 and 14, and an electron beam gun (not shown) and a wafer retainer 15 associated with a heating coil 16. The three sources 11, 12 and 13 are formed of component elements of a complex oxide such as yttrium, barium and copper, and, for this reason, the three sources 11, 12 and 13 as a whole constitute a source for a complex oxide. The evaporation chamber 11 is coupled to a certain vacuum source (not shown), and a gas nozzle for an oxygen gas 17 is directed to the wafer retainer 15. A mercury lamp 18 provides an ultra-violet light radiation, and the ultra-violet light radiation formed contains an ultra-violet light of a wavelength of about 2537 angstroms.

Another process using the vacuum evaporation system starts with preparation of the sources for the complex oxide 12, 13 and 14 and an intermediate structure of a semiconductor device 19. The intermediate structure 19 is mounted on the wafer retainer 15 and, then, heated to about 660 degrees in centigrade. The evaporation chamber 11 is evacuated, and the sources 12, 13 and 14 are heated with electron beams produced by the electron beam gun. Then, the component elements, i.e., yttrium, barium and copper are evaporated and travel over the evaporation chamber 11 toward the intermediate structure 19. The oxygen gas is blown onto the major surface of the structure 19 with the ultra-violet light radiation at about 2 kilo-watts. so that a superconductive oxide is deposited on the major surface of the intermediate structure 19 in a low pressure ambient of about $10^{-3}$ torr, followed by an appropriate lithography stage for patterning a wiring strip. The superconductive oxide is represented by the molecular formula of $YBa_2Cu_3O_x$ and shows the superconductivity at about 42 degrees in Kelvin scale.

For comparison use, a wiring strip is formed by using the same vacuum evaporation system without any assistance of the ultra-violet light radiation. When the wiring strip is formed at about 700 degrees in centigrade, the wiring strip shows the superconductivity at about 63 degrees in Kelvin scale, however, if the intermediate structure is decreased in temperature to about 660 degrees in centigrade during the deposition, no superconductivity takes place in the wiring strip.


Third embodiment

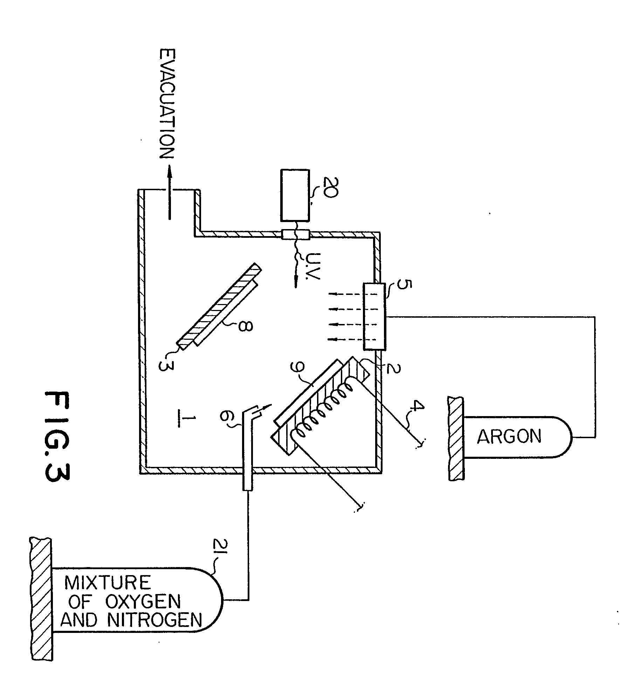

Turning to Fig. 3 of the drawings, there is shown another sputtering system which is similar in construction to the sputtering system shown in Fig. 1 with the exception of a source of ultra-violet light radiation 20 and a gaseous mixture supplied to the major surface of a substrate, and, for this reason, component units are designated by like reference numerals designating the corresponding units of the sputtering system shown in Fig. 1. In the sputtering system shown in Fig. 3, the source of ultra-violet light radiation 20 produces an argon excimer laser with a wavelength of about 126 nano-meter, and the oxygen source is replaced with a source of mixture containing oxygen and nitrogen. In this instance, the nitrogen is about 1 % by volume.

Prior to the deposition stage, a target of $YBa_2Cu_{3.6}O_x$ and the single crystal magnesium oxide substrate 9 are prepared. The target 8 and the substrate 9 are retained on the target holder 3 and the wafer retainer 2, respectively. The substrate is heated to about 630 degrees in centigrade, and the sputtering is carried out in a plasma produced from an argon gas. The plasma is about 5 centi-meters in diameter, about 750 eV in energy, about 90 milli-amperes in beam current and about 2 milli-amperes/$cm^2$ in ion density, and the gaseous mixture is supplied from the source 21 to the major surface of the substrate 9 with the assistance of the argon excimer laser. After the deposition, the superconductive oxide film is patterned to form a wiring strip. The wiring strip shows the superconductivity at about 40 degrees in Kelvin scale.

For comparison use, a wiring strip is formed on a substrate in the same conditions without any assistance of the argon excimer laser. The sputtering conditions are similar to those described above. The wiring strip for the comparison use is about 20 ohms-cm in the room temperature, however, no superconductivity takes place.

Fourth embodiment

Still another wiring strip is formed by using the RF magnetron sputtering system shown in Fig. 1. Prior to the deposition, the target 8 is replaced with another target represented by the molecular formula of $BiCaSrCu_2O_{6-x}$, and the argon gas is changed to a gaseous mixture containing argon and oxygen. The argon to oxygen ratio is adjusted to 1 : 1. The substrate is heated to about 650 degrees in centigrade, and the deposition is carried out with the assistance of the ultra-violet light radiation from the mercury lamp 7. The radiation is produced at 1 kilo-watt, and the ultra-violet light is about 2537 angstroms in wavelength. On the substrate 9 is deposited a superconductive oxide film which is substantially identical in composition with the target, and the superconductive oxide film is patterned to form a wiring strip. The wiring strip shows the superconductivity at about 68 degrees in Kelvin scale.

However, if a wiring strip is formed without any assistance of the ultra-violet light radiation, the wiring strip is about 60 ohms-cm at the room temperature but does not show any superconductivity.

As will be understood from the foregoing description, the wiring strip formed through the process according to the present invention shows the superconductivity even if the deposition is carried out a low temperature ambient not greater than about 650 degrees in centigrade. This is resulted from the combination of the ultra-violet light radiation and the oxygen gas directed to the major surface of the substrate.

Although particular embodiments of the present invention have been shown and described, it will be obvious to those skilled in the art that various changes and modifications may be made without departing from the principle and scope of the present invention. For example, the ultra-violet light radiation may be produced by using a mercury lamp producing an ultra-violet light ranging from about 184.9 nano-meter to about 253.7 nano-meter. In another process, the ultra-violet light radiation is produced by using a high-power vacuum radiation source producing a fluorine laser light with a wavelength of about 157 nano-meter, however, the ultra-violet light radiation may be produced by using a high-power vacuum radiation source producing an excimer laser light selected form the group consisting of an argon excimer layer light with a wavelength of about 126 nano-meter, a xenon-chrorine excimer laser light with a wavelength of about 308 nano-meter, a krypton-fluorine excimer laser light with a wavelength of about 249 nano-meter, an argon-fluorine excimer laser light with a wavelength of about 193 nano-meter, and a krypton-chrorine excimer laser light with a wavelength of about 222 nano-meter in still another process of the present invention.

**Claims**

1. A process of forming a wiring strip of a superconductive oxide, comprising the steps of:

a) preparing a source of an oxygen gas, a source for a complex oxide, an intermediate structure of a semiconductor device and a vapor-phase crystal growth system equipped with a source of an ultra-violet light radiation;

b) placing said source for said complex oxide and the intermediate structure of said semiconductor device in said vapor-phase crystal growth system;

c) creating a relatively low temperature ambient around the intermediate structure of said semiconductor device; and

d) producing a vapor of said complex oxide for depositing the superconductive oxide on the intermediate structure of said semiconductor device, characterized in that the deposition is carried out in the presence of said oxygen gas with the assistance of said ultra-violet light radiation.

6

FIG. 1

FIG. 2

FIG.3